# EUROPEAN PATENT SPECIFICATION

(11) **EP 3 609 679 B1**
(45) Date of publication and mention of the grant of the patent: **27.10.2021**
(21) Application number: 18713979.5
(22) Date of filing: 03.04.2018
(51) Int. Cl.: B29C 64/106, B29C 64/245, B33Y 10/00, B33Y 70/00, B33Y 80/00, B29C 64/188

(54) **METHOD OF 3D-PRINTING PRODUCING A COMPONENT FOR USE IN A LIGHTING DEVICE**
3D-DRUCKVERFAHREN ZUR HERSTELLUNG EINER KOMPONENTE ZUR VERWENDUNG IN EINER BELEUCHTUNGSVORRICHTUNG
PROCÉDÉ D'IMPRESSION 3D PRODUISANT UN COMPOSANT À UTILISER DANS UN DISPOSITIF D'ÉCLAIRAGE

(30) Priority: 10.04.2017 EP 17165676
(43) Date of publication of application: 19.02.2020
(73) Proprietor: Signify Holding B.V., 5656 AE Eindhoven (NL)
(72) Inventor: HIKMET, Rifat, Ata, Mustafa, 5656 AE Eindhoven (NL); VAN BOMMEL, Ties, 5656 AE Eindhoven (NL); VAN HAL, Paulus, Albertus, 5656 AE Eindhoven (NL)
(74) Representative: Verweij, Petronella Daniëlle
(86) International application number: PCT/EP2018/058450
(87) International publication number: WO 2018/188988

(56) References cited:
- EP-A1- 3 061 546
- US-A1- 2015 352 792
- US-A1- 2016 320 771

## Description

### FIELD OF THE INVENTION

The invention relates to a method of 3D-printing producing a component for use in a lighting device according to claim 1.

Said component comprises a flexible substrate and a polymer material or a monomer material. The invention further relates to a lighting device according to claim 14, comprising a component produced by the method according to the invention.

### BACKGROUND OF THE INVENTION

It is expected that the current practice in global manufacturing will be transformed by the widespread introduction of Additive Manufacturing. Additive Manufacturing is best known as 3D-printing. Further, the most widely used 3D-printing process is known as Fused Deposition Modelling (FDM). FDM printers are used in printing various shapes using e.g. various polymers, metals or ceramics. Such materials (usually processed in the form of a filament) may be heated to their melting point and subsequently be extruded. As a result, the material may be deposited layer by layer in order to create a three dimensional object. FDM printers are relatively fast, low cost and can be used for printing complicated 3D objects. Said 3D-printing processing may be further developed in the production of luminaires and lighting solutions.

An FDM printer typically has a build plate and an extrusion head, which includes a liquifier and a dispensing nozzle. In operation, the extrusion head receives 3D-printable material in the form of a filament. A thermoplastic material is widely used as such a filament. For example: Inside the liquifier the thermoplastic filament is heated to a flowable temperature, which typically is a temperature higher than the glass transition temperature of the thermoplastic material. The heated filament is then extruded at a desired flow rate through the nozzle, wherein the extrudate is typically referred to as a "bead". The bead is deposited along a tool path on a building surface, which can be an upper surface of the build plate or of a pre-existing deposited layer. The deposition of a bead creates a layer, and a 3D object is created by stacking multiple layers on top of each other. A controller controls processing variables such as the movement of the extrusion head in a horizontal plane, the movement of the build plate in a vertical direction, and the feeding of the filament into the extrusion head. After the printed layers have solidified, the finished 3D object can be removed from the build plate.

Successfully 3D-printing an object comprises some preferred conditions. Some examples may be provided by EP3061546A1, US2016/320771A1 or US2015/352792A1. One the one hand, it is sometimes desired that the object remains adhered to the build plate during printing, because an insufficient adhesion of the printed object to the build platform may undesirably cause the object to shift, warp or delaminate from the build plate during the printing process; which may result in a failed or poor-quality object. On the other hand, it is sometimes preferred that the object is removable from the build plate without damaging the object; the adhesion of the object to the build plate should thus not be 'inseparably' large or 'difficult' (by requiring post-processing steps). Yet on another hand, it is desired that a thermal stress occurring in the printed object during shrinking of the printed layers (or the whole object) does not lead to an undesired deformation of the object or to the formation of cracks; which may occur when the object is constrained during cooling down.

Hence, for successfully 3D-printing an object, it may be necessary to find a balance between said preferred conditions and corresponding phenomena. However, as indicated above, the advantage provided by one condition may be a disadvantage for another. New approaches, which advantageously address the disadvantages of each of said conditions, are therefore needed to improve 3D-printing of an object.

### SUMMARY OF THE INVENTION

It is an object of the invention to provide an improved method of 3D-printing producing a component for use in a lighting device. Thereto, the invention provides a method of 3D-printing producing a component for use in a lighting device, the component comprising a flexible substrate having a stiffness and a first shape, and a polymer material, the method comprising printing the polymer material onto the flexible substrate in a printing structure; wherein the printing structure causes the first shape of the flexible substrate to change into a second shape when the polymer material shrinks after printing. Herein, an internal stress in the polymer material exerts a bending force on a surface area of the flexible substrate, wherein the bending force forces a displacement of the flexible substrate into the second shape.

Within the same object of the disclosure a monomer material may mutatis mutandis be provided instead of said polymer material. Hence, in an aspect, the disclosure provides a method of 3D-printing producing a component for use in a lighting device, the component comprising a flexible substrate having a stiffness and a first shape, and a monomer material, the method comprising printing the monomer material onto the flexible substrate in a printing structure; wherein the printing structure causes the first shape of the flexible substrate to change into a second shape when the monomer material shrinks after printing. Herein, a polymerization stress of the monomer material (as explained in this application in more detail below) may exert a bending force on a surface area of the flexible substrate. The bending force may force a displacement of the flexible substrate into the second shape.

Said second shape may be a pre-determined shape. Pre-determined may include the knowledge of how the transformation the first shape of the flexible substrate will change into the second shape. Such knowledge may e.g. be obtained by simulations of polymer cooling or monomer polymerization.

Said method of producing a component for use in a lighting device results in said 3D-printed component for use in a lighting device. Such a component may comprise a complicated shape with a single or a plurality of curvatures due to optical, structural, thermal, electronic or aesthetic requirements. In some examples, said component may be one of (or may be part of one of) a lamp, a reflector, a cover, a light guide, a blind, a light engine, a heat sink, a cable guide, a lens, a substrate accommodating electronics, a collimator, a connector, a luminaire housing or a luminaire. Said lighting device may be a luminaire, a lamp, a light pole, an electronics device comprising a light source, or a lighting device comprised within a vehicle. The method of producing a component for use in a lighting device, as provided in the present invention, may therefore be an efficient and effective manufacturing technique for producing said components, because complicated structures may be produced in association with complicated shapes (comprising one or a plurality of curvatures).

Said component comprises a flexible substrate and a polymer material or a monomer material. The polymer material or the monomer material is printed onto the flexible substrate in a particular printing structure. As the printing structure shrinks (e.g. either by cooling down in case of a polymer material or by polymerization shrinkage in case of a monomer material), an internal stress may be created in the printing structure (e.g. either a thermal stress in case of a polymer material or a polymerization stress in case of a monomer material). Said internal stress may exert a bending force on a surface area of the flexible substrate. Thus, as a result of the internal stress, the shrinking of the printing structure may exert a bending force acting on the flexible substrate. As the flexible substrate is able to deform, wherein the amount of deformation may depend on the flexible substrate's stiffness, the particular printing structure may be chosen in such a way that the flexible substrate deforms into a second shape. Namely, a deformation wherein the bending force forces a displacement of the flexible substrate into the second shape. Said deformation and second shape is a desired deformation and pre-determined deformation. Hence, said method for producing a component for use in a lighting device may advantageously utilize the shrinking of the printing structure for forming the flexible substrate into a second shape. The invention therefore provides a novel 3D-printing approach of producing a component; in particular a component for use in a lighting device, but alternatively any other objects or components may advantageously be produced with said method. This may be components in for example electronic devices, optical devices, and wearable devices.

The method according to the invention may advantageously apply knowledge about the expected shrink patterns of the printing structure to form the substrate into a second shape. As the forming of such a substrate is previously done with conventional manufacturing techniques, such as e.g. cold deformation bending or thermoforming (pressing), the method provided in the present application provides an advantage over such conventional techniques, because the use of 3D-printing allows for more complicated structures to be printed in association with such a flexible substrate. Moreover, a shaped substrate may now be directly connected with a structure by means of said 3D-printing without post processing. This reduces manufacturing steps and improves manufacturing efficiency, particularly for components for use in lighting devices, wherein parts with a complicated shape require complicated properties such as thermal, electrical, optical and mechanical requirements. The invention thus turns the disadvantages of thermal stresses in the 3D-printing into a novel and advantageous 3D-printing methodology of producing components.

Another advantage is that the present invention does not experience a delamination of layers or undesired warping due to internal stress, e.g. thermal stress, because the flexible substrate is not constraint to move into the second shape. Namely, for example, a thermal stress provided in the printed layers, which is provided due to a hot layer printed onto a cold layer, will be utilized to force the flexible substrate into the second shape. Hence, a thermal stress in the printed structure may be advantageously controlled in forming the component. Hence, an advantageous method of producing a component for use in a lighting device with 3D-printing is provided.

In an embodiment, the method according to the invention is provided, wherein the bending force acting on a cross-sectional area of the flexible substrate causes a deforming stress smaller than a yield stress of the flexible substrate. Thus, the method according to the invention is provided, wherein the bending force leads to elastic deformation of the flexible substrate. In such an embodiment, the flexible substrate is elastically changed (or: deformed) into the second shape. Hence the second shape of the flexible substrate may elastically return into its initial shape if the printing structure is removed or altered. This may be beneficial in recycling the component. For example, when the printing structure is unstacked (or: detached, or unconnected) from the flexible substrate after printing, the flexible substrate may return to the initial shape it had before the printing structure being printed onto the flexible substrate.

In an embodiment, the method according to the invention is provided, wherein the bending force acting on a cross-sectional area of the flexible substrate causes a deforming stress larger than a yield stress of the flexible substrate. Thus, the method according to the invention is provided, wherein the bending force leads to plastic deformation of the flexible substrate. In such an embodiment, the flexible substrate is plastically changed (or: deformed) into the second shape. Hence the second shape of the flexible substrate may remain even when then the printing structure is altered or detached, e.g. removed, fileted, trimmed. Furthermore, by plastic deformation, the flexible substrate may also be strain hardened, such that the flexible substrate changes into the second shape and simultaneously improves in strength.

In another example, the bending force acting on a cross-sectional area of the flexible substrate causes a deforming stress higher than flexural stress to bend the flexible substrate. In some examples. This may lead to visco-elastic deformation of the substrate. The bending force may also lead to viscous deformation of the flexible substrate.

In an embodiment, the method according to the invention may further comprise: if the polymer material is printed, applying a thermal treatment for shrinking, and wherein the internal stress is a thermal stress; or if the monomer material is printed, applying a photo polymerization treatment for shrinking the monomer material by polymerization of the monomer material into a polymerized material, and wherein the internal stress is a stress due to polymerization. Such a thermal treatment for shrinking may comprise uniformly cooling the component, either actively with active cooling or passively at a fixed ambient temperature. Optionally, in some examples, a thermal treatment for shrinking may be applied, wherein the component is provided with a local thermal treatment for shrinking, such that e.g. different parts of the component may be shrank at different rates to achieve a desired second shape of the flexible substrate.

If a monomer material is printed, applying a photo polymerization treatment for shrinking the monomer material into a polymerized material by polymerization of the monomer may also provide a component for use in a lighting device according to the present invention. Namely, polymerization of the monomer material into a polymerized material will allow the monomer material to shrink. Although this is an alternative shrink mechanism compared to thermal shrinking, shrinking due to polymerization may also be utilized for producing said component. The advantage of using said shrinking mechanism based on polymerization is that the 3D-printing process may comprise monomer materials for printing. Furthermore, due to photo polymerization, shrinking may be induced locally by directed light beams, which provides more freedom in shaping the flexible substrate into the desired second shape.

In a further embodiment, the method may comprise if both the polymer material and the monomer material are printed in the same 3D-printing process for producing the component, applying, within said same 3D-printing process, a thermal treatment for shrinking the polymer material and a photo polymerization treatment for shrinking the monomer material by polymerization of the monomer material into a polymerized material. Such an embodiment may be advantageous as the 3D-printing process may utilize both a polymer material as well as a monomer material in producing the component.

The printing structure causes the flexible substrate to change into a second shape when the polymer material or the monomer material shrinks after printing. Namely, an internal stress in the polymer material or the monomer material may exert a bending force on a surface area of the flexible substrate, wherein the bending force forces a displacement of the flexible substrate into the second shape. Thus, as the polymer material or the monomer material shrinks, the printing structure may govern a change of the flexible substrate into the second shape. Printing properties of the printing structure may therefore have an effect on said change and may lead to the second shape. Hence, said printing structure may comprise at least one print characteristic from the group of: perforations, grooves, a patterned distribution of polymeric material, or a difference in polymeric material composition. Such at least one print characteristic may be advantageous, because it may drive the flexible structure to change into a second shape. Namely, said internal stress (either a thermal stress or a polymerization stress) may be directed accordingly to provide said bending force on a surface area of the flexible surface, such that desired locations of the flexible substrate may deform into the second shape. As such print characteristics may only be possible with 3D-printing, such an embodiment clearly differentiates from conventional manufacturing techniques such as thermoforming, bending or pressing.

For example, if a polymer material is printed, grooves may be advantageous to cool an area or a volume of the printing structure faster, which may cause a built up of more thermal stress into said area or volume, which may subsequently exert a higher bending force on a surface area of the flexible substrate. Said higher bending force may allow to displace the flexible substrate in a second shape with a higher angle of curvature compared to the initial shape of the flexible substrate. Another example, if a polymer material or a monomer material is printed, the printing structure may comprise a perforation to accumulate internal stress (either a thermal stress or a polymerization stress) in an area around the perforation. Such an accumulated internal stress may contribute to a bending force exerted on a surface area of the flexible substrate. Thus, perforations and/or grooves may be advantageous to allow the printing structure to cause the flexible substrate to change in a desired (pre-determined) shape during shrinking.

For example: The printing structure may comprise a print characteristic of a patterned distribution of polymeric material. Such a patterned distribution of polymeric material comprises the printing of polymeric material in a pattern, such that the printed pattern causes the flexible substrate to change into the desired second shape during shrinking. For example, a polymer line printed onto a flexible substrate may primarily shrink in the longitudinal direction of the line, causing the flexible substrate to bend, resulting in a curvature along the longitudinal direction of the line. When a plurality of polymer lines are printed, each polymer line may cause a curvature of the flexible substrate along the longitudinal direction of said line. Therefore, the flexible substrate may curve into a second shape comprising a plurality of bends (curvatures). Moreover, applying a thicker line comprising more polymeric material may exert a larger bending force compared to a thinner line comprising less polymeric material; which allows for playing in the angle of said curvature. Furthermore, printing a pattern of a hollow cylinder may cause the flexible substrate to uniformly bend in all directions, as the hollow cylinder may shrink inwards; thus allowing the flexible substrate to change into a dome shape. Further, printing a pattern of a hollow five-point star shape may cause the flexible substrate to bend into a relief of a five-point star shape, as the hollow five-point star may shrink inwards. Even further, another complicated patterned distribution of polymeric material may be printed, such that the flexible substrate may change into a more complicated second shape.

For example: The printing structure may comprise a print characteristic of a difference in polymeric material composition. Such a difference in polymeric material composition comprises the printing of different densities polymeric material, printing polymeric material with different filler content, printing polymeric material with different types of polymers, etc. Such print characteristic may affect the shrinking of the printing structure, and hence the change of the flexible substrate into the second shape, because the difference in material composition may e.g. improve heat transfer, provide sections with different polymeric materials having different glass transition temperatures and therefore provide a different temperature difference for cooling, alter internal stress accumulation due to the presence of fillers or fibers, etc. As such a difference in polymeric material composition may be easily applied in 3D-printing, causing a flexible substrate to change into a second shape by means of said printing structure may be an advantageous method for producing a component for use in a lighting device, which component may be complicated due to thermal, mechanical, optical, electrical, aesthetic requirements.

Said polymer material or monomer material may be a filament material, wherein the filament material may comprise a filler such as carbon fiber, glass, pigment, a metal flake, etc. Moreover, the polymer material or monomer material may be comprised by a 3D-printing material, wherein the 3D-printing material may comprise multiple different materials such as metals, ceramics, or organic materials.

Said replacement may cause the flexible substrate to deform into a second shape having an (or at least one) angle of curvature. In an embodiment, said displacement of the flexible substrate into the second shape corresponds to a minimum bending angle being at least 5 degrees, more preferably at least 8 degrees, most preferably at least 10 degrees. Hence, in an embodiment the flexible substrate, when in the second shape, comprises a bending angle of at least 5 degrees, more preferably at least 8 degrees, most preferably at least 10 degrees. Such a minimum bending angle is preferred, because the method of producing a component for use in a lighting device may be a more effective method compared to other conventional production methods.

Said printing the polymer material or the monomer material onto the flexible substrate in a printing structure may be printing the polymer material or the monomer material inseparably onto the flexible substrate in a printing structure. Inseparably may indicate that the polymer material or the monomer material are stacked onto the flexible substrate in such a way that the adhesion between said materials and the flexible substrate is sufficient enough to prevent detachment during normal use of the resulting component. A person skilled in the art may read 'inseparably' in such a manner for 3D-printing. The polymer material or monomer material may e.g. be stacked onto, or at least partly mechanically connected to the flexible substrate.

Said method of producing a component for use in a lighting device may comprise printing a polymer material or a monomer material, or a combination of both. In embodiments, a polymer material may be selected from the group of, or may be at least one of: poly methyl methacrylate; polystyrene; polyethylene; polyethyleneterephthalate; polycarbonate; polyphenylsulfone; polyphenylene sulfide; polypropylene. In embodiments, a monomer material may be selected from the group of, or may be at least one of reactive groups: Acrylate, methacrylate, vinyl ether, thiolene system (i.e. comprising a thiolene group for photo polymerization), epoxy groups. Other polymer materials or monomer materials, or compositions of both, may also be suitable such as: BisphenolA dimethacrylate, Bisphenol A ethoxylate diacrylate, hexandioldiacrylate, Bisphenol-A epoxy.

The polymer material may comprise a first polymer material in mixture with at least one further polymer material and/or at least one monomer material. The monomer material may comprise a first monomer material in mixture with at least one further monomer material and/or at least one polymer material.

Cooling a polymer material beyond its glass transition temperature may lead to solidification of the polymer material. Hence, from the glass transition temperature onwards, such cooling may lead to shrink of the polymer material and may lead to the accumulation of internal stress, namely thermal stress. As mentioned before, the present invention advantageously utilizes said stress to provide a method of 3D-printing producing a component for use in a lighting device. It may therefore be preferred to provide a relatively large temperature drop for shrinking the polymer material (i.e. a temperature difference in cooling process; namely a temperature difference between a glass transition temperature of the polymer material and an end temperature of a produced component, e.g. ambient room temperature). Such a large temperature drop may, for example, cause more accumulation of thermal stress between polymer layers and/or between a polymer layer and a substrate onto which the polymer layer is printed.

Thus, the polymer material, as used in the method according to the invention, may comprise a relatively high glass transition temperature. Relatively high may e.g. indicate a temperature difference of at least 80 degrees between the glass transition temperature and an ambient temperature at which the component is produced (at the end of production). Hence, in an embodiment, a temperature difference between a glass transition temperature of the polymer material and an end temperature of a produced component may be at least 80 degrees, or at least 100 degrees, or at least 150 degrees, or at least 200 degrees, or between 80 and 140 degrees. For example, material Polycarbonate has glass transition temperature of 145 degrees Celsius, hence a temperature difference with room temperature being 20 degrees Celsius is 125 degrees Celsius. Furthermore, in a further embodiment, the glass transition temperature of the polymer material may at least be 80 degrees Celsius, at least 100 degrees Celsius, at least 120 degrees Celsius, at least 140 degrees Celsius, above 150 degrees Celsius, or between 100 and 180 degrees Celsius. Moreover, referring to the last embodiment, said embodiment may further comprise an end temperature of a produced component according to the invention, wherein the end temperature is at ambient room temperature common to the location wherein the method according to the present invention is applied.

Nevertheless, in case when the polymer material comprises a relatively low glass transition temperature, a less stiff substrate may be selected to induce more deformation of the flexible substrate.

For example: A larger deformation is induced by the polymer material for a larger temperature difference between the substrate material and the glass temperature of the polymer. Hence, when using PC (Tg = 140 degrees Celsius) the deformation may be larger than when using PET (Tg = 70 degrees Celsius). In both cases the molten material adheres to the substrate in a physical way: Van der Waals interaction. Furthermore, typically the substrate is not heated to have the largest temperature difference.

In an embodiment, the substrate material may comprise chemical reactive groups at a substrate surface to realize a chemical bond between the polymer or monomer material and the substrate material. In this way other adhesion forces may be included, next to the general Van der Waals forces, to get the physical adhesion between the printed material and the substrate material.

The flexible substrate is characterized by a stiffness. Said stiffness is a measure of the resistance of an object to deformation in response to an applied force. Said stiffness is an extensive property which depends on the material of the flexible substrate and its shape. For example, for an element in tension or compression the axial stiffness is defined by the cross-sectional area multiplied with the Young's modulus, divided by the length of the element. Said Young's modulus is an intensive property of the material of the flexible substrate. For example, polymers may have a (room temperature) Young's modulus in the range of 0.1 Gpa to 10 GPa, whereas glass may have a Young's modulus in the range of 50 Gpa to 90 Gpa, whereas metals may have a Young's modulus of 60 GPa and larger. Said flexible substrate may be a foil, a plate or a lamination of stacked layers; said flexible substrate may comprise a square, circular, I-shaped, or another shaped cross-section. The thickness of the substrate may preferably be in the range between 0.1 millimeter and 5.0 millimeter, more preferably between 0.3 millimeter and 3 millimeter, as such a thickness may be more suited to bend into elaborate second shapes.

In an embodiment, the flexible substrate may comprise a flexible substrate material, the flexible substrate material being at least one of PC, ABS, PE; glass, silica, aluminum, or copper. Thus, the flexible substrate may comprise a polymer, a ceramic, or a metal; or any composite thereof.

As mentioned before, said method of producing a component for use in a lighting device results in said 3D-printed component for use in a lighting device. Such a component comprises a flexible substrate and a polymer material or a monomer material. The flexible substrate may provide a function for use in lighting.

Such a function may be an optical function or a thermal function. Hence, in an embodiment, the flexible substrate may comprise a reflective surface. Hence, in an embodiment, the flexible substrate may comprise a reflective surface directed to the side onto which the polymer material or the monomer material is printed onto the flexible substrate. Such an embodiment is advantageous, because the flexible substrate may e.g. be used as a reflector component within a lighting device. A curved shape of such a reflector may then be advantageously manufactured by printing a polymer material or monomer material on a flat flexible substrate and the subsequent shrinking of the filament material to cause a curved reflector shape. Such a reflective surface may also act as a radiating surface for improved thermal performance of a component of a lighting device, because such a reflective surface may lower the emissivity of said component and hence be less prone to radiative heat transfer. Furthermore, such a reflective surface may serve to guide light (e.g. laser) beams as part of a component for use in a lighting device. For example, the printing structure may be printed as a reflector housing, wherein the printing structure causes the flexible substrate to change into a second shape of a reflector, wherein the flexible substrate comprises a reflective surface for providing the functionality of a reflector. As a result, the method of 3D-printing according to the invention of producing a component for use in a lighting device provides an advantage over conventional production techniques, because the component (having the multiple functions for use in lighting) may be integrally produced in a single production methodology with 3D-printing and associated printing possibilities. Namely, 3D-printing allows for printing complicated structures. The present invention provides an improved 3D-printing methodology wherein the printing structure, as mentioned before, causes the flexible substrate to change into a second shape, providing a desired component.

Moreover, such a function may be a lighting function. In an embodiment, the flexible substrate comprises a light source. Such an embodiment is advantageous, because a light source may be part of the flexible substrate, such that the component (as produced by the method according to the invention) may already comprise a light source when the printing process according to the present invention is completed. Such an embodiment may provide a cost-efficient, labor-efficient, simplified production of a lighting device comprising a component with a flexible substrate comprising a light source. For example, the flexible substrate may be a polymer foil comprising LED light sources. Due to the printing structure, which may serve as a lamp base component, the flexible substrate may change into a pre-determined dome shape, by implementing the method of the invention. Since the flexible substrate already comprises a light source, the resulting component may be a lamp base, with a dome shaped substrate serving as a light 'bulb' giving light. Said flexible substrate comprising a light source may be LED strip; a polymer, metal or ceramic substrate accommodating a LED light source; a transparent substrate material comprising a light source and/or a fluorescent gas.

In an embodiment, the printing structure comprises a light source and/or a light source fixture. Such an embodiment is advantageous, because a light source may be part of the printing structure, such that the component (as produced by the method according to the invention) may already comprise a light source and/or a light source fixture when the printing process according to the present invention is completed. Such an embodiment may provide a cost-efficient, labor-efficient, simplified production of a lighting device comprising a component with a printing structure comprising a light source and/or comprising a light source fixture. A light source such as a LED light source may for example be printed with a 3D-printing methodology into a printing structure onto a flexible substrate. Moreover, a light source fixture may be printed into a printing structure, such that the attachment of light source may be facilitated.

Furthermore, in an embodiment, the flexible substrate may comprise a light source and a reflective surface, such that the printing structure may cause the flexible substrate to change into a second shape when the polymer material or the monomer material shrinks after printing. Said second shape may be the shape of a lamp component. Thus, said flexible substrate may already provide a reflector, a light source and (by the method of the present invention) the desired shape of said lamp component for use in e.g. a lamp or other lighting device.

Further, in an embodiment, the flexible substrate may comprise at least one electrical component selected from the group of a solid state light source, a sensor, a loudspeaker, an energy harvesting device, a photovoltaic cell, or combinations thereof.

Furthermore, such a function may be an optical function. In an embodiment, the flexible substrate material comprises a transparent or translucent material. Further, in an embodiment, the flexible substrate material comprises a transparent or translucent foil. Such an embodiment is advantageous because the component for use in a lighting device may require a window, a light guide, a lens or a transmissive part. Such a transparent foil may comprise transparent areas having square, circular or triangular shapes. The light output pattern of a light source provided on a side relative to the transparent foil may therefore be controlled. Such a transparent foil may also be coated with a luminescent material, such that the flexible substrate may be changed into a second shape that is required for positioning the luminescent material optically. Such a transparent foil may also serve as a light guide, when a light source is coupled into the transparent material of the flexible substrate. The method according to the invention may therefore be advantageous in shaping such a light guide component in a desired (complicated) shape.

Further, in an embodiment, the flexible substrate may comprise at least one of a protrusion, groove, a ridge or any combinations thereof.

Furthermore, such a function may be an optical function. In an embodiment, the polymer material is transparent and the printing structure comprises one of a scattering particle, a diffractive element, a void, a (light) conversion material, or a light source. Or further, a refractive element, reflective element, translucent element. Such an embodiment may be advantageous to obtain e.g. a shaped diffuser by means of the method according to the invention.

Alternatively, in an embodiment, the flexible substrate is transparent and comprises one of a scattering particle, a diffractive element, reflective element, refractive element, translucent element, a void, a (light) conversion material, or a light source. Such an embodiment may be advantageous to obtain e.g. a shaped diffuser by means of the method according to the invention.

Further, such a function may be an electrical function. In an embodiment, the printing step comprises printing an electrically conductive track for powering electronics. Such an embodiment may be advantageous to obtain a component of a lighting device, because the electronic wiring may be printed, which leads to a more-efficient manufacturing method for such a component. The component made by the method according to the invention may therefore be a plug-and play component for a lighting device, or serve as an electrical connection point, or serve as a fixture for a light source.

In an embodiment, the flexible substrate may comprise an electrically conductive track. Such an embodiment may be advantageous for connecting light sources to said flexible substrate, or for allowing the flexible substrate (changed into the second shape) to serve as a touch interface.

In an embodiment, the method according the invention is provided, wherein the printing step comprises printing a thermally conductive area for spreading heat within the component, wherein said thermally conductive area comprises a printed material with a higher thermal conductivity than the thermal conductivity of the polymer material. Such an embodiment may provide an advantageous method of producing a component, according to the invention, wherein the component comprises a heat sink. A beneficial thermal function is therefore provided. Hence, a complicated heat sink configuration may be provided. As the printing structure is printed onto the flexible substrate, the substrate may e.g. serve as a heat sink e.g. if the flexible substrate is a metal with higher thermal capacity, to which the thermally conductive areas transfer heat towards.

As mentioned before, as a result of the internal stress, the shrinking of the printing structure may exert a bending force acting on the flexible substrate. Said bending force forces a displacement of the flexible substrate into the second shape. Hence, a relation exists between the printing structure and the resulting second shape. A particular printing structure may be chosen in such a way that the flexible substrate deforms into a desired second shape.

Hence, in an embodiment, the printing structure comprises a hollow cylinder; wherein the flexible substrate comprises a circular plate; wherein the second shape comprises a dome. Such an embodiment provides a component comprising a dome shaped flexible substrate. Such a dome shape is achieved because the hollow cylinder shrinks inward, hence applying a uniform bending force along the circumference of said hollow cylinder, which bends the circular plate into a dome. Said hollow cylinder may be of any height, the hollow cylinder comprising a volume with internal stress for at least changing the flexible substrate into the pre-determined dome shape. Such an embodiment may provide an advantageous manufacturing method for producing a component with such a dome shape for use in a lighting device. A dome shape is common for lighting devices, such as for example the head of a light bulb. Thus, the flexible substrate may serve as a luminaire having a desired shaped, produced with an efficient 3D-printing methodology.

For example: the flexible substrate may be a transparent ceramic circular plate comprising LED light sources. By printing e.g. a polymer material onto the flexible substrate in a printing structure, the printing structure comprising a hollow cylinder, the thermal stress occurring in the polymer material of the hollow cylinder may cause the transparent ceramic plate to change into a pre-determined dome shape when said polymer material shrinks after printing. Thus, a component comprising a transparent dome and an integrated LED light sources may be produced. Such a component may for example be part of a lighting device, such as the (light emitting) head of a light bulb.

In an embodiment, the printing structure comprises a hollow square tube; wherein the flexible substrate comprises a circular plate shape; wherein the second shape comprises a saddle shape. Such an embodiment provides a component comprising a saddle shaped flexible substrate. Such a saddle shape is achieved because the hollow square tube shrinks inward and the corners of said square more inward, hence applying a uniform bending force along the circumference of said hollow square tube and applying more bending force at the corners, which in total bends the circular plate into a saddle shape. Such a saddle shape may be advantageous, because a lighting device may comprise a saddle shaped component, which may be difficult to manufacture with a conventional manufacturing technique, while the present invention provides a more efficient manufacturing method based on 3D-printing. For example, said saddle shape may serve as a touch interface for a lighting device, wherein the flexible substrate comprises an electrically conductive track, wherein the flexible substrate comprises an electronic touch sensor.

In some examples, the printing structure may comprise any other hollow shape, comprising a closed circumference, such as a pentagon, octagon, four-point star, five-point star, etc., in order to create a relief in the flexible substrate.

In an embodiment, the printing structure comprises at least one printed line, wherein the second shape comprises a corrugated shape with at least one bend located along an at least one interface of the corresponding at least one printed line and the flexible substrate. Such an embodiment provides a component comprising a substrate with at least one corrugation. Such a corrugated shape is achieved because the at least one printed line shrinks inwards along the longitudinal direction of said line, hence providing a curvature. Such an embodiment may be advantageous to produce components with at least one corrugation, for example a plurality of corrugations, for example a plate with wave shape. Such corrugations may also provide mechanical strength and also serve as reflectors in a lighting device.

In an embodiment, the flexible substrate comprises a rectangular plate shape, wherein the printing structure comprises a single printed line parallel to an edge of the flexible substrate; wherein the second shape is a corrugated shape with a single corrugation. Such an embodiment provides a component comprising a substrate with a single corrugation. The angle of said corrugation may be in the range of 10 degrees (grad) and -60 degrees (grad) with respect to the horizontal rectangular plate shape comprised by the flexible substrate. Said range is more preferably selected from the range 15 degrees, -50 degrees; or most preferably selected from the range 20 degrees, -45 degrees. Namely, luminaires associated with a bend shape, or corrugated shape, may be produced more efficiently with the method according to the invention, as the component of e.g. luminaire housing, light panel or electronics substrate, or heat sink may be produced in one production method without the need of post processing or e.g. assembly. Such a corrugation may also provide mechanical strength (e.g. when strain hardened due to the deformation into the pre-determined corrugated shape and due to the nature of the corrugated shape and its moment of inertia) and also serve as a reflector or light guide in a lighting device.

In an embodiment, the flexible substrate comprises a rectangular plate shape, wherein the printing structure comprises a plurality of printed lines parallel to an edge of the flexible substrate, wherein the second shape is a corrugated structure. Such an embodiment provides a component comprising a substrate with a corrugated structure. For example, when the length of the parallel lines differ, the rectangular plate shape will corrugate with different radii of curvature, which may provide a slice of a concave cylinder shape, or a slice of a cone shape. The slice being e.g. half of the cross sectional area. Such an embodiment is advantageous, because it provides design freedom in producing components. Such a shape may be optically beneficial for light guides or ceiling luminaires.

In other examples, the printing structure may comprise a combination of the shapes mentioned in the embodiments before. The method according to the invention may result in a component for use in a lighting device. It is a further aspect of the disclosure to provide the component according to any one of the method according to the invention.

It is a further aspect of the disclosure to provide an improved component produced by 3D-printing for use in a lighting device. Therefore the disclosure provides a component produced by 3D-printing for use in a lighting device, the component comprising a flexible substrate having a stiffness and a polymer material or a monomer material; wherein the printed polymer material or printed monomer material is stacked onto the flexible substrate in a printing structure; wherein the printing structure is arranged for causing the flexible substrate to change into a second shape when the polymer material or the monomer material shrinks after being printed; wherein an internal stress in the polymer material or the monomer material is arranged for exerting a bending force on a surface area of the flexible substrate, wherein the bending force forces a displacement of the flexible substrate into the second shape. Such a component may be advantageous because the flexible substrate comprised by the component is caused to change into a second shape by a printing structure when the polymer material or the monomer material shrinks after being printed, which proves a component wherein the internal stress is advantageously used to shape the component. The component may be a self-shaping object produced by 3D-printing. Such a component is advantageous for achieving a more-efficient manufacturing process for complicated objects.

In an embodiment, said component may be part of a lamp, a reflector, a cover, a light guide, a blind, a light engine, a heat sink, a cable guide, a lens, a substrate accommodating electronics, a collimator, a connector, a luminaire housing or a luminaire.

In an embodiment, the flexible substrate is elastically deformed into the second shape; or wherein the flexible substrate is plastically deformed into the second shape. In an embodiment, the polymer material has been shrunk by a thermal treatment for shrinking, and wherein the internal stress is a thermal stress; or the monomer material has been shrunk by a photo polymerization treatment for shrinking, and wherein the internal stress is a stress due to polymerization.

In an embodiment, said printing structure may comprise at least one print characteristic from the group of: perforations, grooves, a patterned distribution of printed polymeric material, or a difference in printed polymeric material composition. In an embodiment, the printing structure comprises a light source and/or a light source fixture. In an embodiment, the printed polymer material is transparent and the printing structure comprises one of a scattering particle, a diffractive element, a void, a conversion material, or a light source. In an embodiment, the printing structure comprises an electrically conductive track for powering electronics. In an embodiment, the printing structure may comprise thermally conductive area for spreading heat within the component, wherein said thermally conductive area comprises a printed material with a higher thermal conductivity than the thermal conductivity of the printed polymer material.

In an embodiment, the printed polymer material may be at least one of: poly methyl methacrylate; polystyrene; polyethylene; polyethyleneterephthalate; polycarbonate; polyphenylsulfone; polyphenylene sulfide; polypropylene. In an embodiment, the printed monomer material may be at least one of reactive groups: Acrylate, methacrylate, vinyl ether, thiolene system (i.e. comprising a thiolene group for photo polymerization), epoxy groups. It may be at least one of: BisphenolA dimethacrylate, Bisphenol A ethoxylate diacrylate, hexandioldiacrylate, Bisphenol-A epoxy. In an embodiment, the flexible substrate may comprise a flexible substrate material, the flexible substrate material being at least one of PC, ABS, PE; glass, silica, aluminum, copper.

In an embodiment, the flexible substrate may comprise a reflective surface. In an embodiment, the flexible substrate may comprise a reflective surface. In a related embodiment, the flexible substrate may comprise a reflective surface directed to the side onto which the printed polymer material or the printed monomer material is stacked onto the flexible substrate. In an embodiment, the flexible substrate comprises a light source. In an embodiment, the flexible substrate material comprises a transparent or translucent material. In an embodiment, the flexible substrate material comprises a transparent or translucent foil. In an embodiment, the flexible substrate is transparent and comprises one of a scattering particle, a diffractive element, a void, a (light) conversion material, or a light source, or an electronic component (as mentioned in the method above). In an embodiment, the flexible substrate may comprise an electrically conductive track.

In an embodiment, the printing structure comprises a hollow cylinder; wherein the flexible substrate comprises a circular plate; wherein the second shape comprises a dome. In an embodiment, the printing structure comprises a hollow square tube; wherein the flexible substrate comprises a circular plate shape; wherein the second shape comprises a saddle shape. In an embodiment, the printing structure comprises at least one printed line, wherein the second shape comprises a corrugated shape with at least one bend located along an at least one interface of the corresponding at least one printed line and the flexible substrate. In an embodiment the flexible substrate comprises a rectangular plate shape, wherein the printing structure comprises a single printed line parallel to an edge of the flexible substrate; wherein the second shape is a corrugated shape with a single corrugation. In an embodiment the flexible substrate comprises a rectangular plate shape, wherein the printing structure comprises a plurality of printed lines parallel to an edge of the flexible substrate, wherein the second shape is a corrugated structure.

The examples and advantages provided by similar embodiments of any one of the methods (of 3D-printing producing a component for use in a lighting device) according to the invention apply similarly (or mutatis mutandis) to the embodiments provided by the component (produced by 3D-printing for use in a lighting device) according to the invention.

It is further object of the invention to provide an improved lighting device. Hence, the invention provides a lighting device comprising a component produced by the method according to the invention. The advantages as mentioned before for the component produced by the method according to the invention apply mutatis mutandis for the lighting device according to the invention. The disclosure may also/alternatively provide a method of producing such a lighting device. Such a method comprises the steps of the method of 3D-printing producing a component for use in a lighting device, wherein further said component is assembled into a lighting device.

It is a further aspect of the disclosure to describe a 3D-printer. The disclosure thus further relates to a 3D-printer. Hence, the disclosure provides a 3D-printer for producing a component for use in a lighting device, wherein the 3D-printer performs any one of the methods according to the invention. As mentioned before, any one of the methods according to the invention (as also summarized in all embodiments) provides an advantageous method of 3D-printing for producing a component for use in a lighting device, wherein the method advantageously utilizes the shrinking (and/or its related internal stress) of a printing structure for forming a flexible substrate into a second shape.

The disclosure further relates to a computer program product for a computing device. Hence, the disclosure provides a computer program product for a computing device, the computer program product comprising computer program code to perform the methods of the present invention mentioned above when the computer program product is run on a processing unit of the computing device; wherein the computer program product may be executed by a computing device associated with the 3D-printer according to the invention. The computer program product may advantageously calculate the second shape of the component produced by the method according to the invention and implement the method of producing said component with the 3D-printer according to the disclosure.

Thus, aspects of the disclosure may be implemented in a computer program product, which may be a collection of computer program instructions stored on a computer readable storage device which may be executed by a computer. Said computer may be associated with the 3D-printer. The instructions of the present disclosure may be in any interpretable or executable code mechanism, including but not limited to scripts, interpretable programs, dynamic link libraries (DLLs) or Java classes. The instructions can be provided as complete executable programs, partial executable programs, as modifications to existing programs (e.g. updates) or extensions for existing programs (e.g. plugins). Moreover, parts of the processing of the present instructions may be distributed over multiple computers or processors.

The disclosure further relates to a system comprising a component for use in a lighting device with 3D-printing. Hence, the disclosure provides a system comprising a component for use in a lighting device according to the invention and the lighting device.

Furthermore, the disclosure provides a system comprising the 3D-printer according to the disclosure and the computer program product according to the disclosure wherein a processor associated with the 3D-printer serves as the processing unit of the computing device. In such a system, the computer program product may drive the 3D-printer into performing the method according to the invention for producing a component for use in a lighting device. Such a system may be advantageous to control the printing process. In some examples, the computer program product may be adapted to provide a visual indicator on a visualization device on an expected outcome of the 3D-printing process. Said processor may be part of a smartphone, computer, smart wearable such as a smart glass, or notebook.

The invention provides a method of producing a component for use in a lighting device with 3D-printing, the component comprising a flexible substrate and a printing material, the method comprising printing the printing material onto the flexible substrate in a printing structure; wherein the printing structure causes the flexible substrate to change into a second shape when the printing material shrinks after printing; wherein an internal stress in the printing material exerts a bending force on a surface area of the flexible substrate, the flexible substrate being characterized by a stiffness, wherein the bending force forces a displacement of the flexible substrate into the second shape. In an embodiment, the printing material may be a polymer material, a monomer material, a metal, or a composite material.

The invention provides a method of 3D-printing producing a component for use in a lighting device, the method comprising: printing a printing structure of a 3D-printable material onto a flexible substrate; shrinking of the printing structure resulting in an internal stress in the printing structure which exerts a bending force on at least a portion of the flexible substrate to cause a deformation of the flexible substrate into a significantly different second shape. Significantly indicates that the deformation of the flexible substrate is visible and/or comprises a bend angle of at least 5 degrees. In an embodiment, said method is provided, wherein the 3D-printable material comprises a polymer material, a monomer material or a mixture thereof. Further, in an embodiment, said method is provide, the method further comprising: if the polymer material is printed, applying a thermal treatment for shrinking, and wherein the internal stress is a thermal stress; or if the monomer material is printed, applying a photo polymerization treatment for shrinking the monomer material by polymerization of the monomer material into a polymerized material, and wherein the internal stress is a stress due to polymerization; or if a mixture of the polymer material and monomer material is printed, applying both the mentioned photo polymerization treatment and the thermal treatment.

The invention provides a method of 3D-printing producing a component for use in a lighting device, the component comprising a flexible substrate having a stiffness and a first shape, and a polymer material, the method comprising printing the polymer material onto the flexible substrate in a printing structure; wherein the printing structure causes the first shape of the flexible substrate to change into a second shape when the polymer material shrinks after printing; and wherein shrinking of the printing structure resulting in the exertion of a bending force on a surface area of the flexible substrate causing the first shape of the flexible substrate to change into a second shape.

### BRIEF DESCRIPTION OF THE DRAWINGS

The invention will now be further elucidated by means of the schematic non-limiting drawings:
Figs. 1A and 1B depict schematically, by non-limiting example, an embodiment of a method (1B) of 3D-printing producing a component (1A) for use in a lighting device, wherein the printing structure comprises a hollow cylinder. Figure 1 (1A) also depicts schematically a component produced by 3D-printing, a lighting device and a system comprising said component and lighting device;
Fig. 2 depicts schematically, by non-limiting example, an embodiment of a method of 3D-printing producing a component for use in a lighting device, wherein the printing structure comprises a ring-shaped printed line. Figure 2 also depicts schematically a component produced by 3D-printing;
Fig. 3 depicts schematically, by non-limiting example, an embodiment of a method of 3D-printing producing a component for use in a lighting device, wherein the printing structure comprises a hollow square tube. Figure 3 also depicts schematically a component produced by 3D-printing; and
Fig. 4 depicts schematically an embodiment of a method of 3D-printing producing a component for use in a lighting device; wherein the printing structure comprises a plurality of printed lines. Figure 4 also depicts schematically a component produced by 3D-printing.

### DETAILED DESCRIPTION OF THE EMBODIMENTS

A phenomena associated with 3D-printing is material shrinking and the occurrence of thermal stress. For example: A polymer material may expand when the temperature of the polymer material is increased, whereas a polymer material may shrink when the temperature of the polymer material is decreased. A 3D-printed object may comprise two layers of polymer material stacked on top of each other. The top layer of polymer material may comprise a temperature which is higher than the temperature of the bottom layer of polymer material. Such a stack of layers may be provided in 3D-printed objects during the printing of the object, wherein a warm printing layer is deposited onto a colder printed layer. Said stack of layers may subsequently reach a thermal equilibrium temperature, wherein during this 'cooling' process the warmer top layer may contract relative to the colder bottom layer due to thermal shrinking. When an equilibrium temperature is reached, e.g. the stack of layers is 'cooled down' to room temperature, said thermal contraction of the top layer relative to the bottom layer may result in thermal stress in both layers; e.g. tension in the initially warm top layer and compression in the initially cold bottom layer. As a consequence of these thermal stresses, the stack of layers may bend when the thermal stress exceeds the mechanical stiffness of the stack of layers.

Moreover, if one of said layers is prevented from deformation due to a constraint, thermal stresses may remain in the stack of layers. Such thermal stresses may cause undesired effects such as edge curling, delamination, crack formation, etc. For example: The bottom layer of said stack of layers may be adhered to a build plate and hence be constrained from deformation. The stack of layers may be forced to bend due to the occurring thermal stresses, but may not be able to bend due to the constraint. The thermal stresses therefore remain in the material and exert a force on the build plate. Said force may also be exerted by the top layer onto the bottom layer, as the top layer is constrained from deformation by its internal adhesion with the bottom layer. As a result, a delamination or a crack may e.g. occur at locations where a thermal stress exceeds the internal adhesion between the top layer and the bottom layer. Furthermore, edge curling may e.g. occur at edges where the thermal stress exceeds the adhesion of the stacked layer to the build plate.

A similar phenomena associated with 3D-printing is monomer material shrinking due to polymerization of the monomer material. Similarly to the phenomena of thermal shrinking explained above, polymerization shrinkage may lead to a polymerization stress analogous to a thermal stress within said monomer (or polymerized monomer) material.

All in all, considering the above, developments in 3D-printing attempt to reduce thermal stress or polymerization stress, such that the quality of the 3D-printed object may be preserved. However, contrary to the present direction of developments, the occurrence of thermal stress or polymerization stress may also be utilized advantageously in the novel 3D-printing method provided by the present invention.

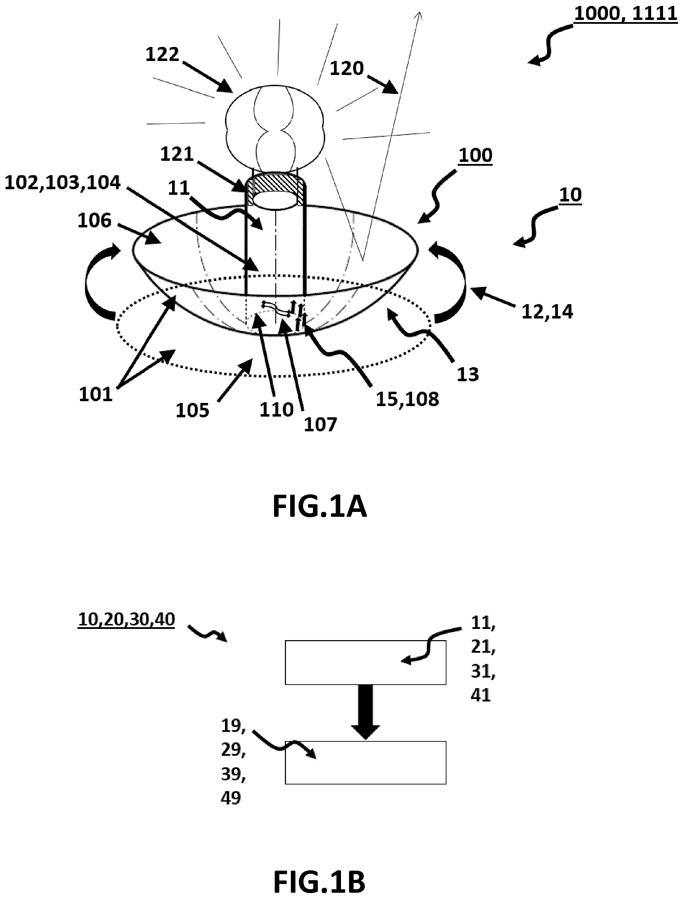

Figure 1A depicts schematically, by non-limiting example, an embodiment of a component 100 for use in a lighting device 1000, which is produced by the method 10 of 3D-printing, as is schematically depicted in figure 1B. Figure 1A also depicts schematically the lighting device 1000, wherein the component 100 produced by 3D-printing is being part of, and a system 1111 comprising the lighting device 1000 and the component 100.

The component 100 comprises a flexible substrate 101 and a polymer material 102. The method comprises printing (depicted as method step 11 in figure 1B, implicitly in figure 1A) the polymer material 102 onto the flexible substrate 101 in a printing structure 103. The printing structure 103 causes the flexible substrate 101 to change 12 into a second shape 13 when the polymer material 102 shrinks 14 after printing. A thermal treatment (depicted as method step 19 in figure 1B) is applied for shrinking said polymer material 102. Consequently, an internal stress 107 in the polymer material 102 exerts 15 a bending force 108 on a surface area 110 of the flexible substrate 101. Hence, the bending force 108 forces a displacement of the flexible substrate 101 into the second shape 13. The thermal treatment may be an active process, but may alternatively may be a non-forced cooling to ambient temperature.

Here, the bending force 108 leads to plastic deformation of the flexible substrate 101. Hence, the produced component 100 will not elastically fall back into its initial shape when the printing structure 103 is removed, altered or heated. Alternatively, the flexible substrate may deform elastically, such that its shape is recovered when the printing structure is for example removed.

The polymer material 102 is Polyethylene (PE), which is supplied in filament form to a 3D-printer (not depicted) that printed the printing structure 103 onto the flexible substrate 101. The printing structure 103 is a hollow cylinder 104 for causing the flexible substrate 101 to change into the second shape 13 of a dome (depicted schematically in exacerbated dimensions). Such a dome is achieved because the hollow cylinder 104 shrinks inward, hence applying a uniform bending force 15 along the interfacial surface area 110 between the bottom cross section of the hollow cylinder 104 and the flexible substrate 101. The angle of curvature of the dome increases with the radius of the hollow cylinder 104. Alternatively, a cone shape may be printed as the printing structure. Such a cone shape also comprises a circular bottom cross section, which provides - compared to the hollow cylinder example - a similar interfacial surface area between the bottom cross section of the cone and the flexible substrate; hence resulting in a dome shape.

The flexible substrate 101 is a thin sheet of Polycarbonate (PC) in the shape of a circular plate 105. The upper surface 106 of the flexible substrate 101 comprises a reflective coating, such that this surface reflects 120 incident light beams. The flexible substrate 101 is characterized by a stiffness based on its cylindrical plate shape and material properties.

Yet alternatively, instead of using a polymer material, the component may comprise a monomer material, wherein the shrinking of the monomer material occurs due to polymerization.

Yet alternatively, if a monomer material is printed, a photo polymerization treatment for shrinking the monomer material is applied by polymerization of the monomer material into a polymerized material, and wherein the internal stress is a stress due to polymerization.

Referring to the embodiment depicted in figure 1, the printing structure 103 comprises a printed thread 121 on the inner surface of the hollow cylinder 104 for connecting a smart light bulb 122. The smart light bulb is auto-powered and comprises a processor and a connectivity interface for control. Said thread 121 is designed to fix the smart light bulb 122 to the component 100. As a result of the method 10 of the invention, the component 100 is advantageously produced and is subsequently used in a lighting device 1000, whereby the lighting device 1000 comprises the component 100 and the smart light bulb 122 (and its optionally associated components, not depicted here). In this assembly, the component 100 serves as a reflector for the smart light bulb 122 (the light source), because a light beam originating from said bulb is reflected 120 by the curved reflective surface area 106.

Furthermore, figure 1 (figure 1A) depicts a system 1111 comprising the component 100 and the lighting device 1000 (and optionally parts associated with the lighting device or component such as control interfaces or devices, which are not depicted here).

Furthermore, still referring to figure 1, the printing structure 103 is uniform in polymer material 102. Alternatively, for example in an embodiment wherein the hollow cone as mentioned before is printed as the printing structure instead of a hollow cylinder, the printing structure may comprise a groove between the base and the top of the cone. Due to such a groove, the polymer material at the base of such a groove may exert a less bending force on the flexible substrate at that location (because of a lesser volume of material at that location to accumulate an internal stress). Hence, no uniform bending force occurs along the interfacial surface area between the bottom cross section of the hollow cone and the flexible substrate. As a consequence, the second shape will be a dome shape, but with a ridge in radial direction at the locations at the base where the groove is located.

Alternative to the embodiment depicted in figure 1, a similar component may be printed, but with a difference in polymeric material composition. Namely, one halve of the hollow cylinder may comprise a different polymeric material composition compared to another halve of the hollow cylinder. The polymeric material in one halve will then a (higher) concentration of carbon fiber filler, such that said one halve may shrink faster than a second halve, and said one halve may shrink more than a second halve. Such a faster shrink and such an increased shrinkage may result in an asymmetric deformation of the flexible substrate which is a circular plate. As a result, such an asymmetric shrinkage leads to an elliptic dome shape. Other shapes may also be formed by means of printing various printing characteristics, such as the ones from the group of perforations, grooves, a patterned distribution of polymeric material, or a difference in polymeric material composition.

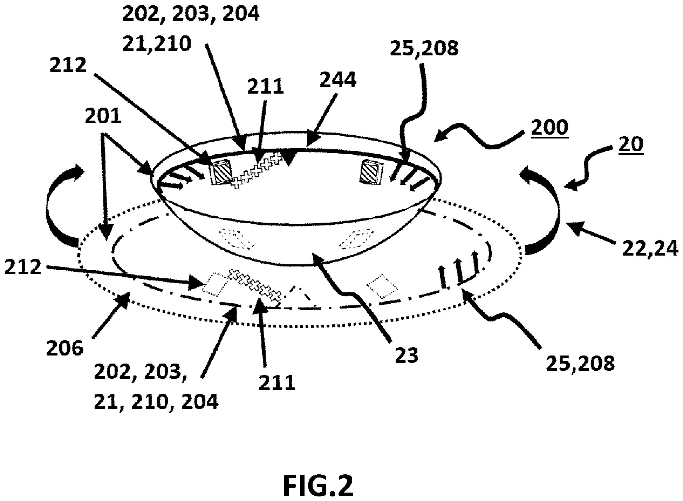

Figure 2 depicts schematically, by non-limiting example, an embodiment of a method 20 of 3D-printing producing a component 200 for use in a lighting device (not depicted), which is similar to the method depicted in figure 1 (1B) embodiment depicted in figure 1 (1A), but comprises a different flexible substrate, printing structure and use in a lighting device.

Partly similar to the embodiment depicted in figure 1, the method 20 comprises printing (implicitly depicted as 21) the polymer material 202 onto the flexible substrate 201 in a printing structure 203. The printing structure 203 causes the flexible substrate 201 to change 22 into a second shape 23 when the polymer material 202 shrinks 24 after printing. A thermal treatment 29 is applied for shrinking said polymer material 202. Consequently, a thermal stress in the polymer material 202 exerts 25 a bending force 208 on a surface area 210 of the flexible substrate 201. Hence, the bending force 208 forces a displacement of the flexible substrate 201 into the second shape 23.

Referring to figure 2, the polymer material 202 is ABS. The flexible substrate 201 is a transparent sheet 206 comprising an electronically conductive track 211 and LED light sources 212. (Four LED light sources in this example). The electronically conductive track 211 is designed for powering the LED light sources and controlling the LED light sources. The printing structure 203 is a ring-shaped printed line 204 with a triangular nudge 244 printed on two opposite locations on the circumference of said ring-shaped printed line 204. The second shape 23 is a dome, because the ring-shaped printed line 204 will shrink inward, hence applying a uniform bending force 25 (i.e. along the whole circumference but in the figure only depicted at several locations for clarity) along the interface (i.e. interfacial surface area 210) of the printed line 204 with the flexible substrate 201. Furthermore, the printing structure 203 also comprises an electronically conductive track, which is printed during a printing step in the printing structure 203. The electronically conductive track 211 of the flexible substrate 201 is therefore in connection with the electronically conductive track of the printing structure, such that desired signals for controlling the LED light sources may be transferred trough the printing structure to other components. The nudge 244 therefore serves as the connection point to other electronic components of a lighting device (not depicted), when the component 200 is used in a lighting device (not depicted) or system (not depicted).

Alternatively, said electronically conductive track may be a thermally conductive track for transferring heat away from the LED light sources into a heat sink. In such an alternative example, the printing step comprises printing a thermally conductive area for spreading heat within the component, wherein said thermally conductive area comprises a printed material with a higher thermal conductivity than the thermal conductivity of the polymer material. Thus, the ring-shaped printed line may comprise e.g. ceramic filler material for improving heat transfer.

As a result of the method 20 of the invention, the component 200 is advantageously produced and is subsequently used in a lighting device (not depicted), whereby the lighting device comprises the component 200. In this example, the component 200 is a head of a lighting device, which emits light through the transparent flexible substrate 201 comprising the LED light sources 212. The curvature of the second shape 23 allows the component to provide optically the desired light output in all circumferential directions. The component 200 is thereby connected to other parts of said lighting device by the nudge 244. The method 20 hence provides an advantageous method of producing a component for use in a lighting device. This lighting device may for example be the head of a light bulb, wherein the component 200 is positioned on top of a driver and/or heat sink.

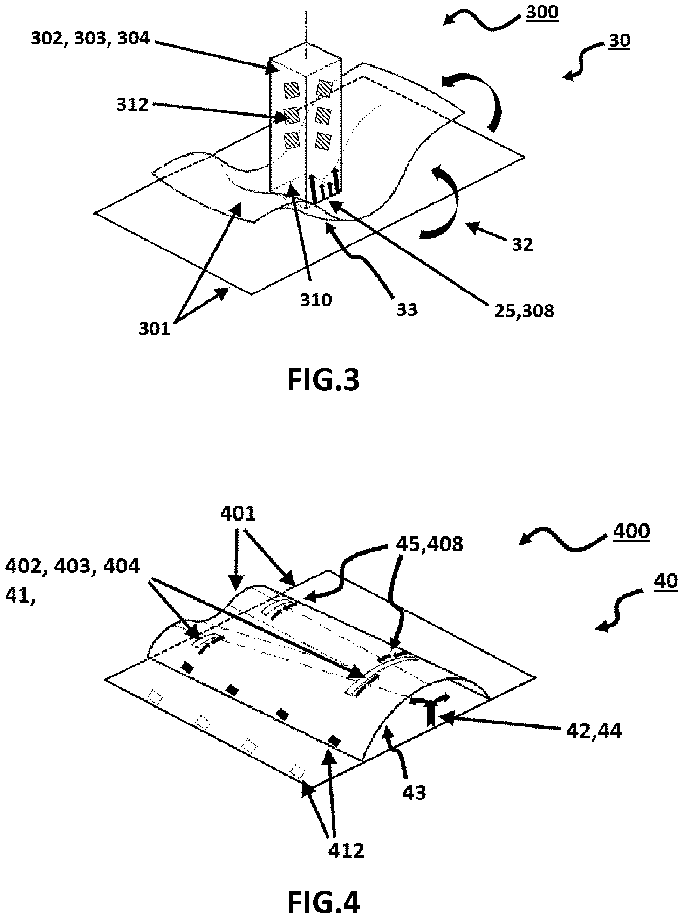

Figure 3 depicts schematically, by non-limiting example, an embodiment of a method 30 of 3D-printing producing a component 300 for use in a lighting device (not depicted), which is similar to the method depicted in figure 1 (1B) and embodiment depicted in figure 1 and/or 2, but comprises a different polymer material 302, flexible substrate 301, printing structure 303 and use in a lighting device.

The polymer material 302 is ABS. The polymer material comprises ceramic filler for improving the heat conductivity. The flexible substrate 301 is a transparent rectangular foil comprising an electronically conductive track (not depicted). Said electronically conductive track acts as a touch sensing sensor, which is connected to a processing unit of a lighting device (not depicted) by means of conducting the signals through the electronically conductive track in the flexible substrate, towards an electronically conductive track printed in the printing structure 303 and subsequently to components in the lighting device.

The printing structure 303 is a hollow square tube 304. As the hollow square tube 304 shrinks inward due to a thermal treatment 39 which cools the printing structure 303, the printing structure 303 causes the flexible substrate 301 to change 32 into a second shape 33. Said second shape 33 is a saddle shape. Such a saddle shape is achieved because the hollow square tube 304 shrinks inward and the corners of said square move inward, hence applying a partly uniform bending force 308 along the circumference 310 of the cross-section of said hollow square tube and applying more bending force at the corners. Furthermore, the printing structure 303 comprises LED light sources 312 which are printed into the printing structure 303 during the printing step. Such LED light sources 312 are powered by an electronically conductive track (not depicted) also printed in the printing structure 303, but may alternatively be inductively powered, or with cables externally coupled in a later manufacturing step. As the printing structure 303 is a hollow square tube 304, a high conductive material such as a metal may be placed inside to serve as a heat sink for the heat generated by the LED light sources 312. This enables the component 300 to be used in association with a heat sink and other components of an overarching lighting device. The touch interface on the flexible substrate may then be used for controlling the light output.

Placing the resulting component 300 in a housing in association with the required electronics and power source will render a lighting device. Thus, the method 30 according to this invention provides an advantageous method of producing a complicated yet functional component 300 for use in a lighting device.

Alternatively, not depicted, in an embodiment, the printing structure may comprise perforations or grooves on one plane of the hollow square tube, such that said plane comprises less polymer material and induces less bending force on the flexible substrate. The flexible substrate associated with that side of the hollow square tube will hence bend less, allowing the saddle shape to be asymmetric. This may be done for adjusting the second shape.

Alternatively, not depicted, in an embodiment, the printing structure may comprise locally a higher concentration of thermally conductive filler, such as carbon fiber, which may improve heat transfer locally. Thus, the heat generated by the LED light sources present in the printing structure may be advantageously spread over the hollow square tube and lead to a heat sink optionally placed within the hollow square tube. The flexible substrate may in some examples also serve as the heat sink, when the thermal storage capacity of the flexible substrate material is sufficient to store some of the heat generated by a light source in either the flexible substrate or the printing structure.

Alternatively, not depicted, in an embodiment, the polymer material which is printed as the hollow square tube may be transparent and comprise one of a scattering particle, a diffractive element, a void or a conversion material. In such a way, the optical properties of the component and corresponding lighting device may be controlled by providing additional features to tune the light of the LED light sources in the printing structure.

Figure 4 depicts schematically, by non-limiting example, an embodiment of a method 40 of 3D-printing producing a component 400 for use in a lighting device (not depicted), which is similar to the embodiment depicted in figure 1 and/or 2, but comprises a different flexible substrate, printing structure and use in a lighting device.

Partly similar to the embodiment depicted in figure 1 and/or figure 2, the method 40 comprises printing (implicitly depicted as 41) the polymer material 402 onto the flexible substrate 401 in a printing structure 403. The printing structure 403 causes the flexible substrate 401 to change 42 into a second shape 43 when the polymer material 402 shrinks 44 after printing. A thermal treatment 49 is applied for shrinking said polymer material 402. Consequently, a thermal stress in the polymer material 402 exerts 45 a bending force 408 on a surface area (not depicted here) of the flexible substrate 401. Hence, the bending force 408 forces a displacement of the flexible substrate 401 into the second shape 43.

Alternatively, a monomer material may be printed as the printing structure. If said monomer material is printed, a photo polymerization treatment for shrinking the monomer material is applied by polymerization of the monomer material into a polymerized material, and wherein the internal stress is a stress due to polymerization.

Referring to figure 4, the polymer material 402 is Polystyrene. The flexible substrate 401 is a transparent sheet of Plexiglas, with a thickness of 4 mm, comprising LED light sources 412. (Four LED light sources on a single side of the flexible substrate, in this example). The LED light sources 412 are powered and controlled when the component 400 is assembled in a lighting device (not depicted). The LED light sources 412 have their light coupled into the Plexiglas sheet such that the flexible substrate 401 serves as a light guide. The printing structure 403 is a plurality of printed lines 404. Said lines 404 are parallel to an edge of the flexible substrate 401. Hence, the second shape 43 is a corrugated structure. Such a corrugated structure is achieved because each one of the printed lines shrinks inwards along the longitudinal direction of said line, hence applying a uniform bending force 45 inwards, hence providing a curvature. (Alternatively, to achieve different second shapes, the plurality of lines may be distributed in different orientations, e.g. a ripple shape may be pre-determined by printing lines from a center to the edges of the flexible substrate). As in figure 1 the printing structure 403 comprises a single line printed on one side of the flexible substrate and two smaller lines upstream of said one side of flexible substrate, the second shape 43 comprises a single corrugation on the one side of the flexible substrate and a double corrugated structure upstream, wherein the corrugations flow into each other.

As a result of the method 40 of the invention, the component 400 is advantageously produced and is subsequently used in a lighting device (not depicted), whereby the lighting device comprises the component 400. In this example, the component 400 is a light guide for use in a curved ceiling luminaire, which guides the light of the LED light sources 412. The curvature of the second shape 43 allows the component to provide optically the desired light output, but at the same time also provide mechanical strength and/or stiffness due to the corrugated shape and corresponding moment of inertia. The method 40 hence provides an advantageous method of producing a component 400 for use in a lighting device.

In an alternative embodiment, not depicted, the flexible substrate may comprise scattering particles or luminescent material for improving the optical behavior of the light guide.

In some examples, not depicted, PMMA filament, having a coefficient of thermal expansion of 77*10-6/K, is printed on a PC substrate having a thickness of 1 mm, having a coefficient of thermal expansion of 67*10-6/K. The PMMA filament is printed to produce a layer of 1 cm height, width of 2 mm and length of 10 cm, wherein the 3D-printer has a nozzle temperature of 250 degrees Celsius and wherein the PC substrate is at room temperature. After cooling down and shrinking a significant deformation, i.e. a uniform bend of approx. 20 degrees was obtained.

And: PC filament is printed on a PC substrate having a thickness of 1 mm. The PC filament is printed to produce a layer of 1 cm height, width of 2 mm and length of 10 cm, wherein the 3D-printer has a nozzle temperature of 280 degrees Celsius and wherein the PC substrate is at room temperature. After cooling down and shrinking a significant deformation, i.e. a uniform bend of approx. 7 degrees was obtained. Depending on the print pattern the uniformity of the bend and shape of the component can be regulated.

## Claims

1. A method of 3D-printing producing a component for use in a lighting device, the component comprising a flexible substrate having a stiffness and a first shape, and a polymer material, the method comprising
- printing the polymer material onto the flexible substrate in a printing structure;
wherein an internal stress in the polymer material of the printing structure exerts a bending force on a surface area of the flexible substrate and causes the first shape of the flexible substrate to change into a second shape when the polymer material shrinks after printing.

2. The method according to claim 1, wherein the bending force leads to elastic or plastic deformation of the flexible substrate.

3. The method according to any one of the preceding claims, wherein the second shape of the flexible substrate comprises a bend angle of at least 5 degrees in respect to the first shape of the flexible substrate.

4. The method according to any one of the preceding claims, the method further comprising
- applying a thermal treatment for shrinking, and wherein the internal stress is a thermal stress.

5. The method according to any one of the preceding claims, wherein the printing structure comprises at least one print characteristic from the group of: perforations, grooves, a patterned distribution of polymeric material, or a difference in polymeric material composition.

6. The method according to any one of the preceding claims, wherein
- the polymer material is one of poly methyl methacrylate, polystyrene, polyethylene, polyethyleneterephthalate, polycarbonate, polyphenylsulfone, polyphenylene sulfide, polypropylene.

7. The method according to any one of the preceding claims, wherein the flexible substrate comprises a reflective surface directed to the side onto which the polymer material is printed onto the flexible substrate.

8. The method according to any one of the preceding claims, wherein the flexible substrate and/or the printing structure comprises a light source.

9. The method according any one of the preceding claims, wherein the flexible substrate material comprises a transparent or translucent foil.

10. The method according to any one of the preceding claims, wherein the polymer material is transparent and the printing structure comprises one of a scattering particle, a diffractive element, a void, a conversion material, or a light source.

11. The method according to any one of the preceding claims, wherein the printing step comprises printing an electrically conductive track for powering electronics.

12. The method according to any one of the preceding claims, wherein the printing structure comprises a hollow cylinder; wherein the flexible substrate comprises a circular plate; and wherein the second shape comprises a dome.

13. The method according to any one of the preceding claims, wherein the printing structure comprises a hollow square tube; wherein the flexible substrate comprises a circular plate shape; and wherein the second shape comprises a saddle shape.

14. A lighting device comprising a component produced according to the method of the claims 1 to 13.

## Patentansprüche

1. Verfahren zum 3D-Drucken zum Herstellen einer Komponente zur Verwendung in einer Beleuchtungseinrichtung, wobei die Komponente ein flexibles Substrat umfasst, das eine Steifheit und eine erste Gestalt und ein Polymermaterial aufweist, wobei das Verfahren Folgendes umfasst
- das Drucken des Polymermaterials auf dem flexiblen Substrat in einer Druckstruktur;
wobei eine interne Belastung in dem Polymermaterial der Druckstruktur eine Biegekraft an einem Oberflächenbereich des flexiblen Substrats ausübt und die erste Gestalt des flexiblen Substrats dazu veranlasst, sich in eine zweite Gestalt zu verändern, wenn das Polymermaterial nach dem Drucken schrumpft.

2. Verfahren nach Anspruch 1, wobei die Biegekraft zu einer elastischen oder plastischen Verformung des flexiblen Substrats führt.

3. Verfahren nach einem der vorstehenden Ansprüche, wobei die zweite Gestalt des flexiblen Substrats einen Biegewinkel von mindestens 5 Grad bezüglich der ersten Gestalt des flexiblen Substrats umfasst.

4. Verfahren nach einem der vorstehenden Ansprüche, wobei das Verfahren weiter Folgendes umfasst
- das Anwenden einer Thermalbehandlung zum Schrumpfen und wobei die interne Belastung eine thermale Belastung ist.

5. Verfahren nach einem der vorstehenden Ansprüche, wobei die Druckstruktur mindestens ein Druckmerkmal von der Gruppe, bestehend aus: Perforationen, Nuten, einer gemusterten Verteilung des Polymermaterials oder einen Unterschied der Polymermaterialzusammensetzung umfasst.

6. Verfahren nach einem der vorstehenden Ansprüche, wobei
- das Polymermaterial aus einem von Polymethylmethacrylat, Polystyrol, Polyethylen, Polyethylenterephthalat, Polycarbonat, Polyphenylsulfon, Polyphenylensulfid, Polypropylen besteht.

7. Verfahren nach einem der vorstehenden Ansprüche, wobei das flexible Substrat eine reflektierende Oberfläche umfasst, die zu der Seite gerichtet ist, an welcher das Polymermaterial auf das flexible Substrat gedruckt wird.

8. Verfahren nach einem der vorstehenden Ansprüche, wobei das flexible Substrat und/oder die Druckstruktur eine Lichtquelle umfasst.

9. Verfahren nach einem der vorstehenden Ansprüche, wobei das flexible Substratmaterial eine transparente oder lichtdurchlässige Folie umfasst.

10. Verfahren nach einem der vorstehenden Ansprüche, wobei das Polymermaterial transparent ist und die Druckstruktur eines von einem Streuteilchen, einem beugenden Element, einem Leerraum, einem Umformungsmaterial oder einer Lichtquelle umfasst.

11. Verfahren nach einem der vorstehenden Ansprüche, wobei der Druckschritt das Drucken einer elektrisch leitfähigen Spur zur Stromversorgung von Elektronikgeräten umfasst.

12. Verfahren nach einem der vorstehenden Ansprüche, wobei die Druckstruktur einen hohlen Zylinder umfasst; wobei das flexible Substrat eine kreisförmige Platte umfasst; und wobei die zweite Gestalt einen Dom umfasst.

13. Verfahren nach einem der vorstehenden Ansprüche, wobei die Druckstruktur ein hohles, quadratisches Rohr umfasst; wobei das flexible Substrat eine kreisförmige Plattengestalt umfasst; und wobei die zweite Gestalt eine Sattelgestalt umfasst.

14. Lichteinrichtung, umfassend eine Komponente, die gemäß dem Verfahren nach den Ansprüchen 1 bis 13 hergestellt wird.

## Revendications

1. Procédé d'impression 3D produisant un composant à utiliser dans un dispositif d'éclairage, le composant comprenant un substrat souple ayant une certaine rigidité et une première forme, et une matière polymère, le procédé comprenant
- l'impression de la matière polymère sur le substrat souple dans une structure d'impression ;
dans lequel une contrainte interne dans la matière polymère de la structure d'impression exerce une force de courbure sur une superficie du substrat souple et amène la première forme du substrat souple à changer en une seconde forme lorsque la matière polymère se contracte après impression.

2. Procédé selon la revendication 1, dans lequel la force de courbure conduit à une déformation élastique ou plastique du substrat souple.

3. Procédé selon l'une quelconque des revendications précédentes, dans lequel la seconde forme du substrat souple comprend un angle de courbure d'au moins 5 degrés par rapport à la première forme du substrat souple.

4. Procédé selon l'une quelconque des revendications précédentes, le procédé comprenant en outre
- l'application d'un traitement thermique pour la contraction, et dans lequel la contrainte interne est une contrainte thermique.

5. Procédé selon l'une quelconque des revendications précédentes, dans lequel la structure d'impression comprend au moins une caractéristique d'impression provenant du groupe de : perforations, rainures, une distribution à motifs de matière polymère, ou une différence de composition de matière polymère.

6. Procédé selon l'une quelconque des revendications précédentes, dans lequel
- la matière polymère est l'une de polyméthacrylate de méthyle, polystyrène, polyéthylène, polyéthylènetéréphtalate, polycarbonate, polyphénylsulfone, sulfure de polyphénylène, polypropylène.

7. Procédé selon l'une quelconque des revendications précédentes, dans lequel le substrat souple comprend une surface réflexive dirigée vers le côté sur lequel la matière polymère est imprimée sur le substrat souple.

8. Procédé selon l'une quelconque des revendications précédentes, dans lequel le substrat souple et/ou la structure d'impression comprend une source de lumière.

9. Procédé selon l'une quelconque des revendications précédentes, dans lequel la matière de substrat souple comprend une feuille transparente ou translucide.

10. Procédé selon l'une quelconque des revendications précédentes, dans lequel la matière polymère est transparente et la structure d'impression comprend l'une d'une particule de dispersion, d'un élément diffractif, d'un vide, d'une matière de conversion, ou d'une source de lumière.

11. Procédé selon l'une quelconque des revendications précédentes, dans lequel l'étape d'impression comprend l'impression d'une piste électriquement conductrice pour alimenter de l'électronique.

12. Procédé selon l'une quelconque des revendications précédentes, dans lequel la structure d'impression comprend un cylindre creux ; dans lequel le substrat souple comprend une plaque circulaire ; et dans lequel la seconde forme comprend un dôme.

13. Procédé selon l'une quelconque des revendications précédentes, dans lequel la structure d'impression comprend un tube carré creux ; dans lequel le substrat souple comprend une forme plate circulaire ; et dans lequel la seconde forme comprend une forme de selle.

14. Dispositif d'éclairage comprenant un composant produit selon le procédé des revendications 1 à 13.
